# EUROPEAN PATENT APPLICATION

(11) **EP 1 637 948 A1**
(43) Date of publication of application: **22.03.2006**
(21) Application number: 04746412.8
(22) Date of filing: 18.06.2004
(51) Int. Cl.: G05B 19/418

(54) **INFORMATION PROCESSING DEVICE AND PRODUCTION DEVICE**

(30) Priority: 20.06.2003 JP 2003176496
(71) Applicant: MATSUSHITA ELECTRIC INDUSTRIAL CO., LTD., Kadoma-shi, Osaka 571-8501 (JP)
(72) Inventor: KINDO, Toshiki, Kanagawa 227-0044 (JP); IKEDA, Takumi, Hyogo 651-0053 (JP); MORIMOTO, Masamichi, Saga 849-0937 (JP); KONISHI, Chikashi, Fukuoka 839-0863 (JP)
(74) Representative: Pautex Schneider, Nicole Véronique
(86) International application number: PCT/JP2004/008943
(87) International publication number: WO 2004/114036

(57) **Abstract**

An information processing apparatus includes a line information storage unit for storing pieces of line information, a data reception unit for receiving numerical control (NC) data for producing a first board, a line identifier acquiring unit for acquiring a line identifier from line identifiers stored in the line information storage unit according to the NC data, and an output unit for outputting the line identifier acquired by the line identifier acquiring unit. Each of the pieces of line information includes a line identifier for identifying a production line of a board, board size information indicating a size of the board that can be produced by the production line identified by the line identifier, and component information about at least one component mountable on the board in the production line identified by the line identifier. The NC data includes board size information and first component information about a component mountable on the first board. The board size information indicates a size of the first board. The line identifier indicates a first production line capable of producing the first board. This information processing apparatus accurately selects a production line appropriate for producing the board.

## Description

### TECHNICAL FIELD

This invention relates to an information processing apparatus that determines a production line according to numerical control (NC) data, a production apparatus that produces boards using the NC data, and other articles.

### BACKGROUND OF THE INVENTION

In production of boards and other components, it is necessary to check a production line in a factory where the production line exists in order to select a conventional production apparatus and a production line including the apparatus mounting electronic components on boards according to numerical control (NC) data.

It takes a long time to checking production lines. Since the same kind of production apparatuses do not have same production efficiency in different lines, it is difficult to select an optimum production line.

In a factory having plural production lines, an optimum production line is selected according to a production schedule or a production commission of each production line. This selection requires producing production schedules or calculating production commissions.

NC data are stored in the production apparatuses. Generally, the NC data are confidential information of companies that owns the production apparatuses, and thus, the NC data must not be acquired or used by, or disclosed to third parties. Thus, the NC data stored in the production apparatuses are generally deleted by an operator or other personnel, after production is completed.

### SUMMARY OF THE INVENTION

An information processing apparatus includes a line information storage unit for storing pieces of line information, a data reception unit for receiving numerical control (NC) data for producing a first board, a line identifier acquiring unit for acquiring a line identifier from line identifiers stored in the line information storage unit according to the NC data, and an output unit for outputting the line identifier acquired by the line identifier acquiring unit. Each of the pieces of line information includes a line identifier for identifying a production line of a board, board size information indicating a size of the board that can be produced by the production line identified by the line identifier, and component information about at least one component mountable on the board in the production line identified by the line identifier. The NC data includes board size information and first component information about a component mountable on the first board. The board size information indicates a size of the first board. The line identifier indicates a first production line capable of producing the first board.

This information processing apparatus accurately selects a production line appropriate for producing the board.

### BRIEF DESCRIPTION OF THE DRAWINGS

Fig. 1 is a block diagram of an information processing apparatus in accordance with Exemplary Embodiment 1 of the present invention.
Fig. 2 is a flowchart for explaining an operation of the information processing apparatus in accordance with Embodiment 1.
Fig. 3 is a schematic diagram of the information processing apparatus in accordance with Embodiment 1.
Fig. 4 shows line information in the information processing apparatus in accordance with Embodiment 1.
Fig. 5 shows NC data in the information processing apparatus in accordance with Embodiment 1.
Fig. 6 shows information about the number of production in the information processing apparatus in accordance with Embodiment 1.
Fig. 7 shows a result of filtering the NC data in the information processing apparatus in accordance with Embodiment 1.
Fig. 8 shows line identifiers in a searched result in the information processing apparatus in accordance with Embodiment 1.
Fig. 9 shows a display of line identifiers and production schedules in the information processing apparatus in accordance with Embodiment 1.
Fig. 10 is a block diagram of an information processing apparatus in accordance with Exemplary Embodiment 2 of the invention.
Fig. 11 is a flowchart for explaining an operation of the information processing apparatus in accordance with Embodiment 2.
Fig. 12 is a schematic diagram of the information processing apparatus in accordance with Embodiment 2.
Fig. 13 is a perspective view of a board in accordance with Embodiments 1 and 2.

### DETAILED DESCRIPTION OF PREFERRED EMBODIMENTS

### FIRST EXEMPLARY EMBODIMENT

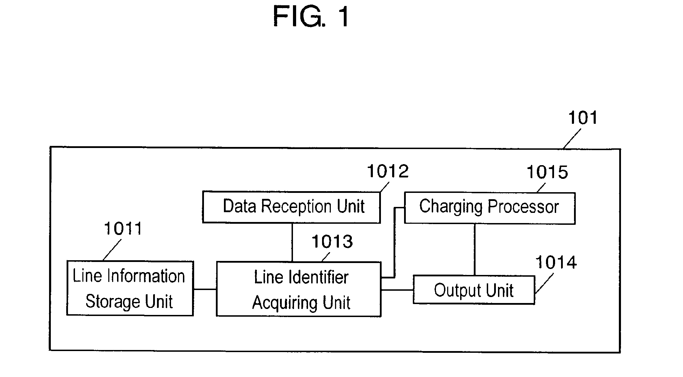

Fig. 1 is a block diagram of information processing apparatus 101 in accordance with Exemplary Embodiment 1 of the present invention. Information processing apparatus 101 includes line information storage unit 1011, data reception unit 1012, line identifier acquiring unit 1013, output unit 1014, and charging processor 1015. Information processing apparatus 101 can be implemented by a general-purpose computer that has hardware resources (e.g. a central processing unit (CPU), main memory, such as a ROM and an EPROM, and record medium) and peripheral devices (e.g. an input device, such as a keyboard and a mouse, and an output device, such as a display device).

Line information storage unit 1011 stores plural pieces of line information. The line information includes information regarding a production line, such as a line identifier, board size information, at least one piece of component information, production capacity information, and production schedule information. The line identifier is for identifying the production line of a board, i.e. a manufacture. The line identifier includes, for example, a line identification number and line identification name. The board size information is information for showing a size of the board that can be produced in the production line identified by the line identifier. The board size information includes information, such as the minimum and maximum sizes of the board (length and width). The component information is information for identifying a component mountable on the board in the production line identified by the line identifier. The component information includes a component ID for identifying the component and an identification name and an attribute (e.g. a size) of the component. The production capacity information is information for showing the production capacity of the production line identified by the line identifier included in the line information. The production capacity information includes information for showing a time taken to produce one piece of the board (e.g. two minutes per one piece), and information about the number of boards that can be produced for 24 hours (e.g. 200 pieces every 24 hours). Generally, the time taken to produce one board piece is calculated according to the number of components mounted on the board, a component configuration pattern, the locations of component suppliers placed around the production apparatus, and other conditions, thus being different for each production line. The production schedule information is information for showing the schedule of producing the board in the production line. The production schedule includes information about the period during which production is possible (from May 10 to Jun 20). Line information storage unit 1011 is in implemented preferably by a nonvolatile record medium, however, can be implemented by a volatile record medium. The line information can be acquired (received) from another information processing apparatus, or be supplied directly from the input device or other devices of information processing apparatus 101.

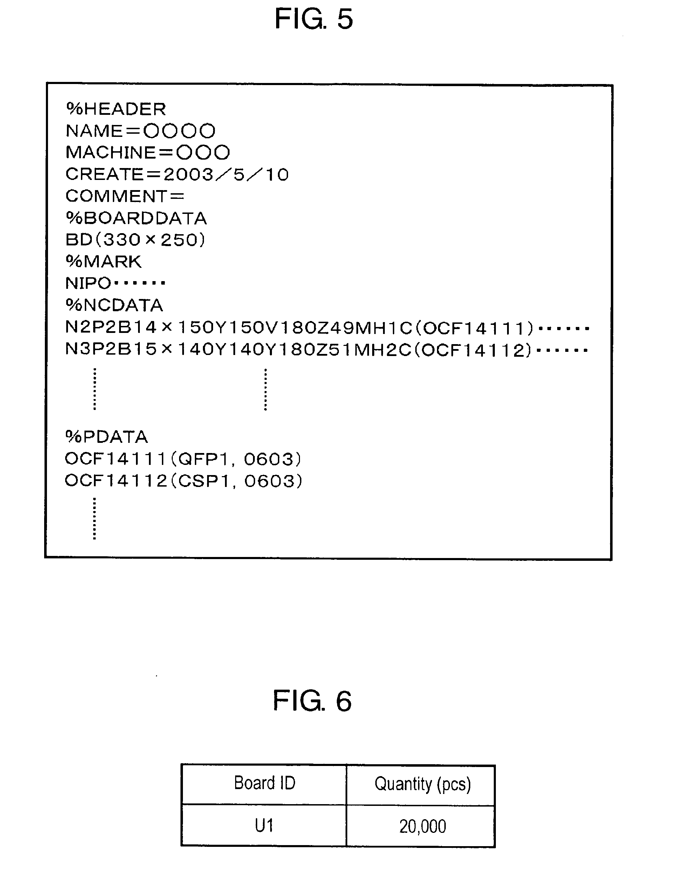

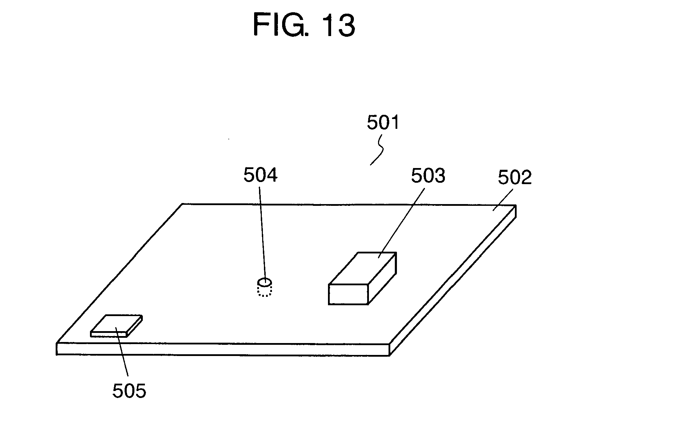

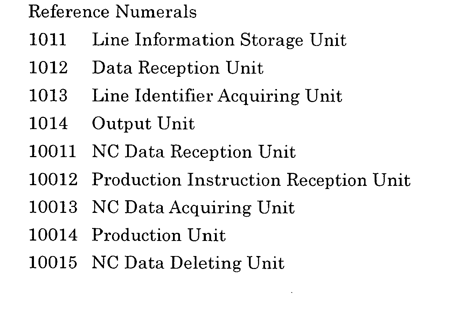

Data reception unit 1012 receives numerical control (NC) data for NC control. The NC data include the board size information and the component information about at least one component (see Fig. 5). Data reception unit 1012 may receive the NC data and production number information. The production number information shows the number of boards to be produced, and is that, for example, "20,000 boards A are to be produced". The term, "reception", includes reading out data from the record medium built in information processing apparatus 101 or an external information processing apparatus, and receiving data through communication lines or broadcasting or from a wireless tag. If reading out data from the record medium built in information processing apparatus 101, data reception unit 1012 can be implemented by, for example, a hard disk drive and software for driving the hard disk drive. If connected via a network with an external information processing apparatus storing the NC data, data reception unit 1012 is implemented by, for example, a network card and software driving the card. If receiving the NC data through broadcasting, data reception unit 1012 is implemented by, for example, a broadcasting receiver. If receiving the NC data from the wireless tag storing the NC data, data reception unit 1012 is implemented by, for example, a wireless-tag reader. The wireless-tag may be attached to the board or other components, such as a case for housing the board. Fig. 13 shows circuit board 501 having wireless-tag 505 having thereon. Wireless Tag 505 is mounted on board 502. Wireless tag 505 stores the NC data for machining board 502, and can transmit the NC data. Board 502 is machined according to the NC data. For example, hole 504 is formed through board 502, and component 503 is mounted on the board according to the NC data.

Based on the NC data, line identifier acquiring unit 1013 acquires the line identifier that indicates a production line capable of producing the board to be produced according to the NC data. Generally, line identifier acquiring unit 1013 can be implemented by, for example, a micro processing unit (MPU) and a memory. Processes for the "acquiring" is generally implemented by software recorded in a record medium, such as a ROM. However, the processes for the "acquiring" can be implemented by hardware (a dedicated circuit).

Output unit 1014 outputs the line identifier acquired by line identifier acquiring unit 1013. This "output" operation includes displaying of data on the display device, transmitting the data to an external information processing apparatus, or producing voice output or printed output. If displaying the line identifier on the display device, output unit 1014 can be implemented by, for example, the display device and software for driving the display device. If the data are transmitted to the external information processing apparatus, the output unit can be implemented by, for example, a network card and software for driving the card. In the case of voice output, output unit 1014 can be implemented by, for example, a loudspeaker and software for driving the loudspeaker. In the case of printed output, output unit 1014 can be implemented by, for example, a network card and software for driving the card.

Output unit 1014 may output the line identifier and a schedule of the producing of the board in the production line identified by the line identifier. In this case, output unit 1014 can generally be implemented by, for example, an MPU and a memory. Processes of "creating a production schedule" are generally implemented by software recorded in a record medium, such as a ROM. However, the processes of "creating a production schedule" may be implemented by hardware (a dedicated circuit).

Charging processor 1015 processes charges in response to information (e.g. a line identifier and production schedule) supplied by output unit 1014 in the following manner. In response to the output of the information from output unit 1014, charging processor 1015 increments value (i) of the charging counter and charges a user based on the value (i) of the counter according to a predetermined rule. For example, charging processor 1015 transmits the value of the counter and user identification information for identifying the user (e.g. an account number) to a bank via a communication line on the day when output unit 1014 supplies the information. Then, the bank debits an account of the user identified by the user identification information with the amount obtained by multiplying the value of the counter by a predetermined amount, thus charging the user. The charging method is not limited to this. For example, and may be various charging methods, such as a credit card. Charging processor 1015 can generally be implemented by, for example, an MPU and memory. Processes of "charging" can generally be implemented by software recorded in a record medium, such as a ROM. The procedure of "charging" may be implemented by hardware (a dedicated line).

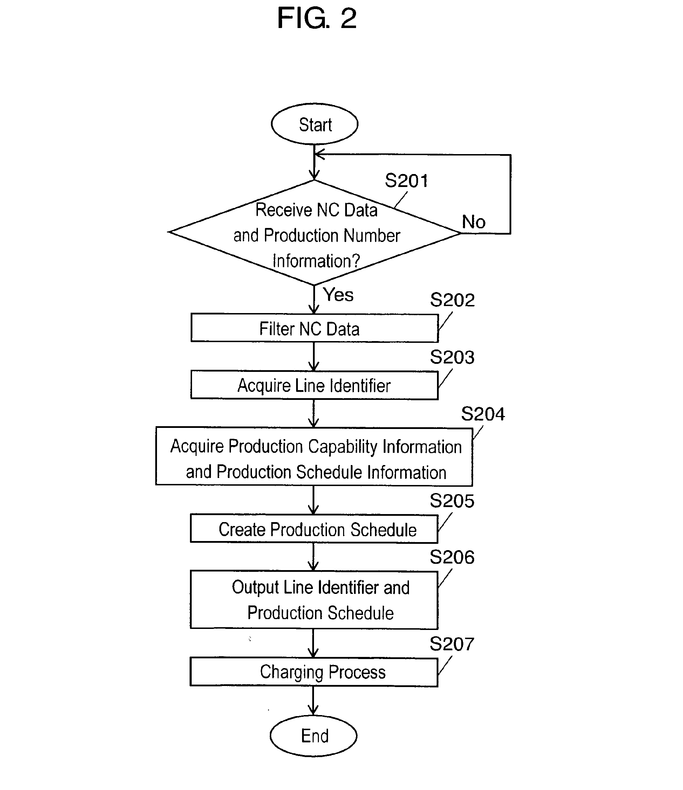

An operation of information processing apparatus 101 of Embodiment 1 will be described with reference to a flowchart shown in Fig. 2.

Data reception unit 1012 determines whether data reception unit 1012 receives the NC data and the production number information (step S201).

If data reception unit 1012 has received them, line identifier acquiring unit 1013 filters the NC data received at step S201, that is, the line identifier acquiring unit acquires the board size information and the component information from the NC data (step S202).

Using the board size information and the component information acquired at step S202, as keys, line identifier acquiring unit 1013 searches the line information stored in line information storage unit 1011, and acquires a line identifier applicable (step S203).

Output unit 1014 acquires, from line information storage unit 1011, the production capacity information and the production schedule information that are identified by the line identifier acquired at step S203, (step S204).

Output unit 1014 creates a production schedule from the production capacity information and the production schedule information acquired at step S204, and the production number information received at step S201 (step S205).

Output unit 1014 outputs the line identifier acquired at step S203 and the production schedule created at step S205 (step S206).

Charging processor 1015 performs a charging process (step S207). Then, the operation of information processing apparatus 101 terminates.

At step S201, data reception unit 1011 may determine whether it has received NC data or not. In this case, output unit 1014 does not create the production schedule, and outputs only the line identifier.

A specific operation of information processing apparatus 101 of Embodiment 1 will be described.

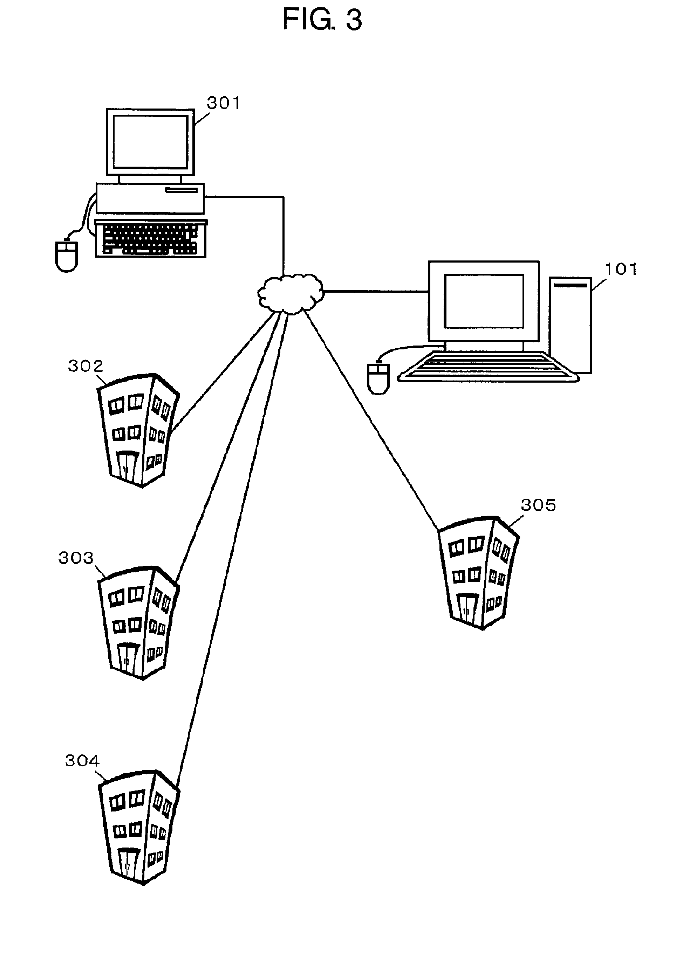

Fig. 3 is a schematic diagram of information processing apparatus 101. Information processing apparatus 101 is coupled to server 301 of a user, server 302 of company A, server 303 of company B, server 304 of company C, and server 305 of a bank.

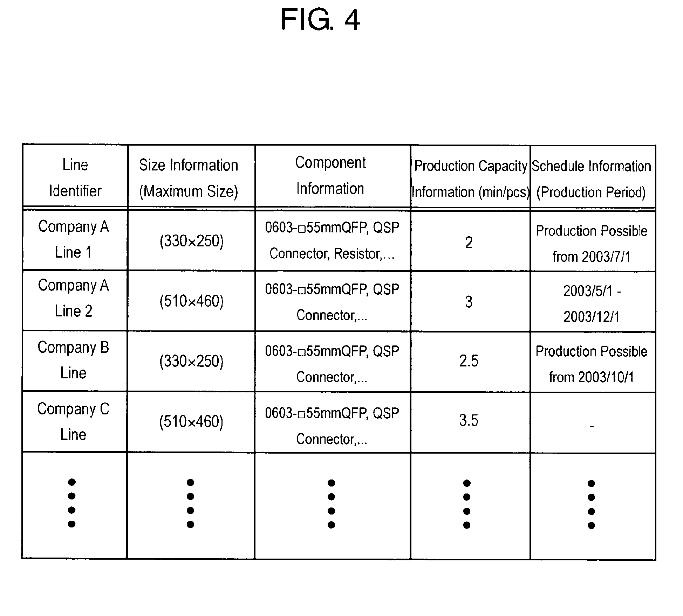

Line information storage unit 1011 stores the line information acquired (received) from each server of the companies. Fig. 4 shows the line information. The line information includes the line identifiers, the board size information (the maximum sizes each indicated as a length by a width), the component information, the production capacity information (e.g. time taken to produce one board), and the production schedule information (periods during which production is possible). For example, the size of the board that can be produced in the production line identified by line identifier "line 1 of company A" is "300×250". The component information of components mountable on the board includes the attributes of the components, such as "0603-□55mmQFP, CSP, connector, resistor, ...". In this case, the "0603-□55mm" shows the sizes of the components. The "0603" represents a size of 0.6×0.3mm. The "□55mm" represents a size of 5×5mm. The QFP and CSP abbreviate a quad flat package and a chip size package, i.e. IC packages, respectively. The component information may include the component ID only. The production capacity of the production line identified by line identifier "line 1 of company A" is "two minutes per piece". The period during which production is possible is "from July 1, 2003".

Data reception unit 1012 receives the NC data and the production number information from server 302 of the user. Fig. 5 shows the NC data. Fig. 6 shows the production number information.

As shown in Fig. 5, the NC data includes the board size information and the component information. The board size information in the NC data is "330×250". The component information includes, for example, the component ID (OCF14111), the component name (QFP1), and the component size (0603). As shown in Fig. 6, the production number information includes the board ID (U1) and a quantity (20,000 pieces). If plural kinds of boards are to be produced, the production number information may include the number of pieces for each kind of the boards.

Next, line identifier acquiring unit 1013 filters the NC data received by data reception unit 1012 as to acquire the board size information and the component information. Specifically, line identifier acquiring unit 1013 searches the NC data with using identifier "BD" for identifying the board size information in the NC data as a key, and acquires "BD (330×259). Line identifier acquiring unit 1013 also searches the NC data with using the identifier "OCF" for identifying components in the NC data as a key, and acquires the component IDs "OCF14111, OCF 14112, ..." Line identifier acquiring unit 1013 searches the NC data with using the component IDs as keys, and acquires the component names and the component sizes identified by the component IDs.

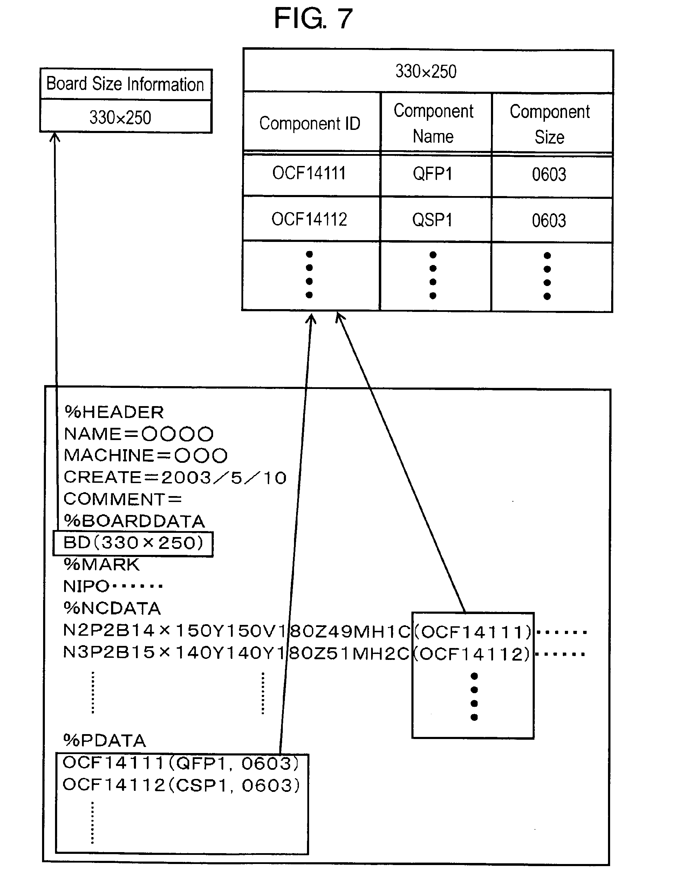

Fig. 7 shows the board information and the component information acquired by the filtering. The board size information is "330×250". The component information includes the component IDs, the component names, and the component sizes. For example, if the component ID is "OCF14111", the component name and the component size are "QFP1" and "0603", respectively. The NC data may include only the component ID only, and may not include the component name or the component size which are not identified by the line identifier. If the NC data include only the component ID, the component information stored in line information storage unit 1101 may include only the component ID. Alternatively, the component information stored in line information storage unit 1011 may include the component name and the component size identified by the component ID.

Next, line identifier acquiring unit 1013 searches the line information stored in line information storage unit 1011 with using the board size information and the component information acquired by the filtering as keys, and acquires the line identifiers. Specifically, line identifier acquiring unit 1013 searches the line information including the board size information corresponding to "330×260" and the component information including "QFP1, 0603", "CSP1, 0603", and acquires the line identifiers included in the line information. If the component information includes the component IDs "OCF14111", "OCF14112", ..., line identifier acquiring unit 1013 searches the line information that includes the board size information corresponding to "330×260", and the component information including "OCF14111", "OCF14112", ... and acquire the line identifiers included in the line information.

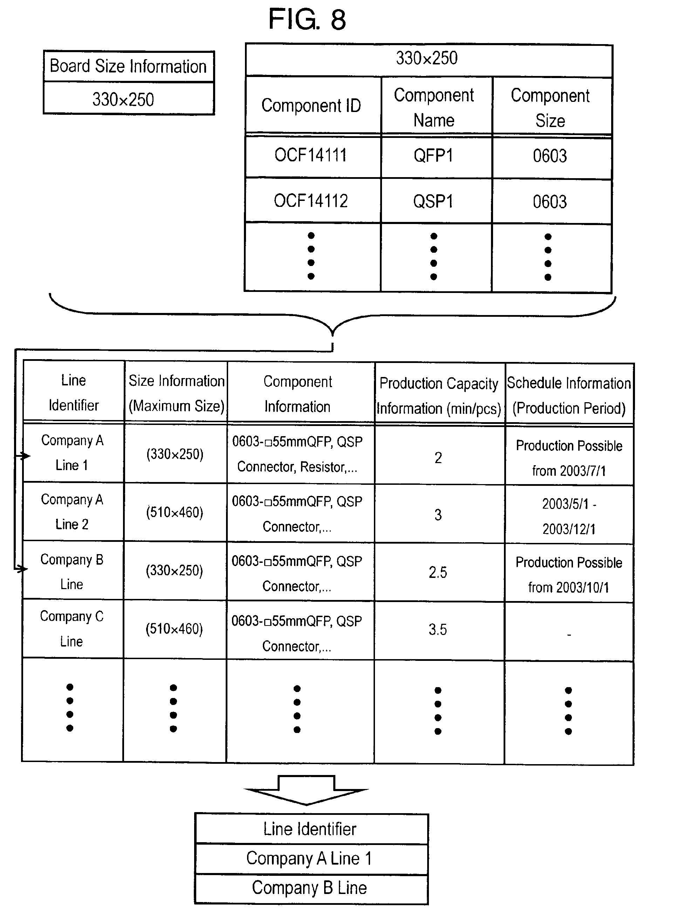

Fig. 8 shows the acquired line identifies. Fig. 8 shows that line identifier acquiring unit 1013 has acquired the information about two line identifiers of "line 1 of company A" and "the line of company B". Line identifier acquiring unit 1013 acquires the line identifiers corresponding to the board size information ("330×250") only. However, the line identifier acquiring unit 1013 may search the line information including the board size information including a value of "330×250", and may acquire the line identifiers included in the line information. In this case, line identifiers of "line 2 of company A" and "the line of company C" are also acquired. That is, in the searching operation with using the board size information as a search key, line identifier acquiring unit 1013 may search the line information including the board size information corresponding to a search key "330 × 250"), and acquire the line identifiers included in the line information. Alternatively, line identifier acquiring unit 1013 may search the line information including the board size information (e.g. "maximum 510×460") covering the value of the search key ("330×250"), and acquire the line identifiers included in the line information.

Next, output unit 1014 acquires, from line information storage unit 1011, the production capacity information and the production schedule information that are identified by the line identifiers ("line 1 of company A" and "the line of company B") acquired by line identifier acquiring unit 1013. for example, as shown in Fig. 4, the production capacity information identified by line identifier "line 1 of company A" is "two minutes per piece (time taken to produce one board)". The production schedule information identified by line identifier "line 1 of company A" is "from July 1, 2003". The production capacity information identified by line identifier "the line of company B" is "2.5 minutes per piece". The production schedule information identified by line identifier "the line of company B" is "from October 1, 2003".

Next, output unit 1014 creates a production schedule from the production capacity information and the production schedule information acquired, and the production number information, "board ID (U1), a quantity (20,000 pieces)" received by data reception unit 1012, in the following manner. First, output unit 1014 calculates "the number of board pieces that can be produced per hour". Next, output unit 1014 divides "quantity" in the production number information by "the number of board pieces that can be produced per hour", to provide "total hours taken to produce the board". Then, output unit 1014 calculates "date of starting production" and "date of completing production" from the "total hours of production" and the production schedule. For example, in production line "line 1 of company A", "the number of pieces that can be produced per hour" is "30", which can be obtained by dividing "60 minutes" by "two minutes per piece". Then, output unit 1014 divides the number of pieces of board "U1" to be produced, that is, divides "20,000 pieces", by "30", and rounds the number to one decimal place, thus providing "666.7" hours of "total hours of production". Output unit 1014 divides "666.7" by "24", and rounds up the fractional portion of the number, thus providing "28 days" of total days taken for production in 24-hour operation.

Then, output unit 1014 acquires "July 1, 2003" as "date of starting production" from the production schedule information. Output unit 1014 also acquires "July 28, 2003" as "date of completing production" by adding "28 days" to the date "July 1, 2003". Similarly, output unit 1014 acquires the production schedule of the production line identified by line identifier "the line of company B". "Date of starting production" is "October 1, 2003". "Date of completing production" is "November 5, 2003". (The total days taken for production in 24-hour operation are "35 days".) Thus, the total days (35 days) of production provided by the line identifier "the line of company B" are 7 days longer than the total days (28 days) of production provided by the line identifier "line 1 of company A". Therefore, for example, the user can select the production line provided by the line identifier "line 1 of company A" as a smaller number of days based on the total days of production as decision-making information. Specific methods of creating the production schedule are not limited to the above method. The production schedule may be created according to actual circumstances (e.g. 7.hour operation) of the production line, or other calculation methods.

Next, output unit 1014 outputs the line identifiers ("line 1 of company A" and "the line of company B"), and the production schedules (e.g. the date of starting production (July 1, 2003) and date of completing production (July 28, 2003)). Alternatively, output unit 1014 may calculate a production commission, i.e. costs and expenses that include the labor cost, overhead expenses, and profit of the manufacturer and exclude the costs of materials, e.g. the boards and components. The production commission can be obtained by multiplying the number of production of "20,000 pieces" and a unit price (e.g. "50 yen per piece") of the board. The information about "unit price of production" may be included in the line information, or may be recorded in the record medium built in information processing apparatus 101. The procedure for calculating the production commission is usually implemented by software record in a record medium, such as a ROM. However, the procedure for calculating the production commission may be implemented by hardware (a dedicated circuit).

The method of calculating the production commission is not limited to the above method. The production commission can be calculated by other methods. For example, if production is started earlier according to order information from an orderer, the production commission can be determined to be higher. This "order information" is information about an order the orderer places with the producer. The order information may includes "information about discount - produce the manufacture at a price as low as possible" and "information about delivery date - produce the manufacture as early as possible". The order information can also be received by data reception unit 1012.

According to this embodiment, the production commission is costs (hereinafter referred to as "processing fee") that include the labor cost, overhead expenses, and profit of the producer without the costs of materials, e.g. a board and components. The production commission may include the costs of materials, e.g. the board and components, the expenses for procurement thereof and others. Common components (e.g. chip resistors), secondary materials, or the like that can be ordered in a large quantity may be different in price between the case where they are ordered by the orderer and the case where they are ordered by the producer. In this, if either of these sides that can purchase them at a lower price orders and purchases them, the total cost of the production can be reduced. Therefore, the production commission can include a processing fee, the total of the processing fee and material costs, the total of the processing fee, the costs of the materials procured by the producer, and the costs of the materials procured by the orderer. More preferably, the production commission includes delivery charges. Output unit 1014 can output plural kinds of the above production commissions.

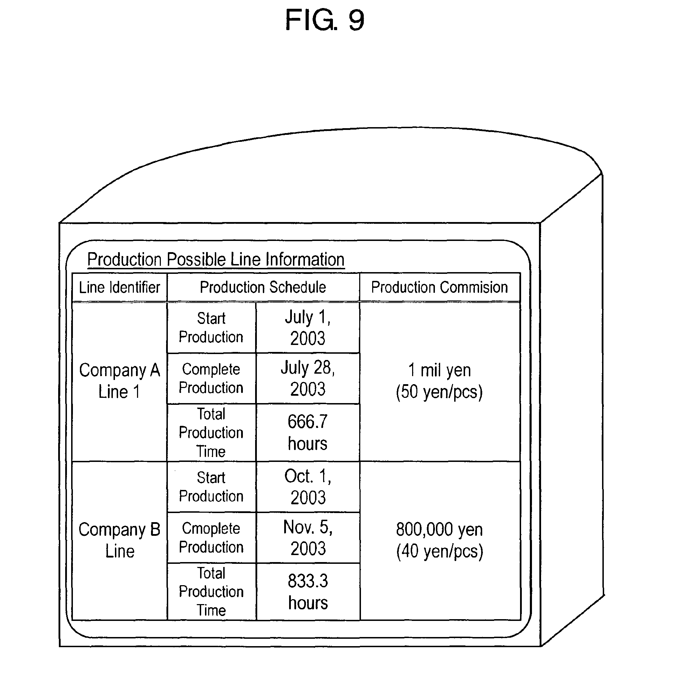

Fig. 9 shows the line identifiers, the production schedules, and the production commissions displayed on a display device. Two production lines provided by the identifiers of "line 1 of company A" and "the line of company B" are displayed. The production schedules indicate dates possible for production, periods during which the production is possible, dates of completing the production, and total hours of the production. The production commission of the production line given by identifier "line 1 of company A" is "1,000,000 yen (50 yen per piece). The production commission of the production line provided by identifier "the line of company B" is "800,000 yen (40 yen per piece). The display device may provide information about the location (e.g. address and telephone number) of the production line identified by the line identifier. The display of the identifiers, production schedules, and production commissions is not limited to that of this embodiment, and may be provided in other display forms. Output unit 1014 outputs and displays data on the display device of information processing apparatus 101. However, the output unit may transmit the data to server 301 of the user. In this case, server 301 of the user may display a line identifier, the production schedule, and the production commission on the display device, or produce voice output or printed output of the commission.

According to this embodiment, output unit 1014 outputs information (the line identifiers, the production schedules, and the production commissions) on two production lines. According to the output results, the user can select the production line identified by "line 1 of company A" that starts production earlier. Alternatively, the user may select the production line identified by "the line of company B" that charges a lower production commission. That is, the user can select a production line most appropriate for needs of the user in production of a board. If information processing apparatus 101 automatically selects a production line according to the NC data, information only on the selected production line may be supplied. In this case, information processing apparatus 101 can automatically deliver the board, the components, and the NC data to the selected production line.

Next, charging processor 1015 performs charging the user of server 301 in the manner described above. The user identification information is previously stored in a record medium built in server 301. Alternatively, charging processor 1015 may transmit information indicating a result of the charging, for example, that "A charge for "xxx yen" will automatically be debited from the bank account of XX on the 20th of the next month.", to server 301 of the user. Server 301 of the user may display such information about the display device, or produce in voice output or printed output of the information.

As described above, according to this embodiment, an (optimum) production line capable of production is selected with using the NC data. Further, since production lines are not unnecessary checked in sight, a production line can quickly be selected. An agent that selects a production line can effectively use information processing apparatus 101 since the apparatus has the charging processing function.

The operation of information processing apparatus 101 of this embodiment may be implemented by software. Additionally, the software may be stored in a server, and distributed by downloading it from the server. Alternatively, the software may be recorded on a record medium, such as a CD-ROM, for distribution.

A program for implementing the operation of this embodiment causes a computer to operate in the following manner. The computer receives the NC data, i.e. data for producing a board and including board size information and component information. Based on the NC data, the computer acquires the line identifier indicating a production line capable of producing the board according to the NC data. The computer outputs the line identifier acquired at the step of acquiring the line identifier.

Alternatively, the computer receives production number information, i.e. information indicating the number of boards to be produced, and the NC data. Based on the NC data, the computer acquires the line identifier indicating a production line capable of producing the board to be produced according to the NC data. The computer outputs the line identifier acquired at the step of acquiring the line identifier, and a production schedule of the board in the production line identified by the line identifier. The computer may further output information showing the production commission.

### EXEMPLARY EMBODIMENT 2

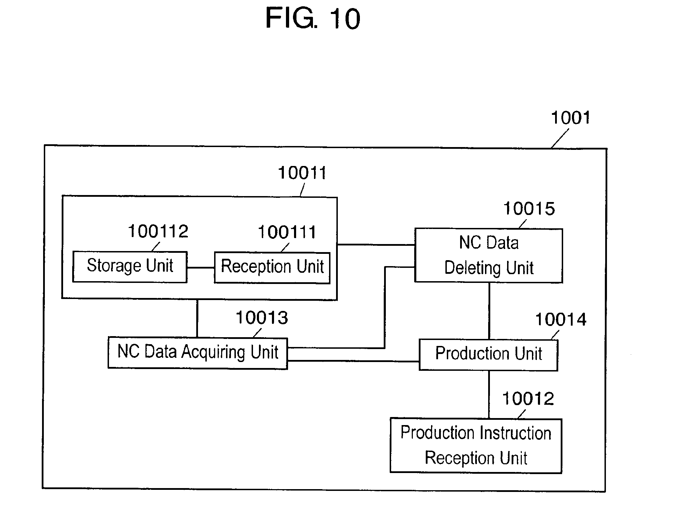

Fig. 10 is a block diagram of production apparatus 1001 in accordance with Exemplary Embodiment 2 of the present invention. Production apparatus 1001 includes data reception unit 10011, production instruction reception unit 10012, NC data acquiring unit 10013, production unit 10014, and NC data deleting unit 10015. NC data reception unit 10011 includes reception unit 100111 and storage unit 100112.

Reception unit 100111 receives NC data. Specifically, reception unit 100111 receives the NC data by reading out them from a record medium built in production apparatus 1001, or from an external record medium coupled to production apparatus 1001, receiving them through communication lines or broadcasting, or from a wireless tag, or acquiring them from a record media mounted on a board, or other methods. If reading out the data from a record medium, reception unit 100111 can be implemented by, for example, a hard disk drive and software for driving the hard disk drive. If being connected via a network with an external information processing apparatus storing NC data, reception unit 100111 is implemented by, for example, a network card and software for driving the card. If receiving the NC data through broadcasting, reception unit 100111 is implemented by, for example, a broadcasting receiver. If receiving the NC data from a wireless tag storing the NC data, reception unit 100111 is implemented by, for example, a wireless-tag reader. As shown in Fig. 13, the wireless tag may be attached to the board, or other components, such as a case for housing the board. Fig. 13 shows circuit board 501 having wireless tag 505. Wireless tag 505 is mounted on board 502. Storing the NC data for machining board 502, wireless tag 505 is capable of transmitting the NC data. Board 502 is machined according to the NC data. For example, hole 504 is formed in board 502, and component 503 is mounted on the board according to the NC data. If acquiring the NC data from a record medium mounted on the board, reception unit 100111 is implemented by, for example, a device for acquiring the data from the record medium. The record medium mounted on the board may include an IC memory chip.

Storage unit 100112 stores the NC data received by reception unit 100111. Storage unit 100112 is implemented preferably by a nonvolatile record medium, however, may be implemented by a volatile record medium.

Production instruction reception unit 10012 receives an instruction to start producing boards. Production instruction reception unit 10012 can be implemented by, for example, an input device, such as a button and switch, and software for driving the input device.

NC data acquiring unit 10013 acquires the NC data received by NC data reception unit 1001. The acquired NC data is stored in a memory. NC data acquiring unit 10013 can generally be implemented by a micro processing unit (MPU) and the memory. Processes of acquiring the data are generally implemented by software. The software is recorded in a record medium, such as a ROM. The processes for the acquisition can be implemented by hardware (a dedicated circuit).

Production unit 10014 processes the NC data and produces the boards, a manufactured object. The production unit is usually implemented by a production apparatus and a controller. The production apparatus is implemented by, for example, hardware. The controller can generally be implemented by an MPU and a memory. Processes of for the production are generally implemented by software. The software is recorded in a record medium, such as a ROM.

NC data deleting unit 10015 deletes all the NC data stored in the record media built in production apparatus 1001 after the boards are produced. Alternatively, NC data deleting unit 10012 may delete the NC data after the NC data is processed and one kind of the boards are produced. NC data deleting unit 10012 may delete the NC data after a predetermined number of boards are produced. NC data deleting unit 10012 can generally be implemented by an MPU and memory. A procedure for deleting the data is generally implemented by software. The software is recorded in a record medium, such as a ROM. However, the procedure for the deletion can be implemented by hardware (a dedicated circuit).

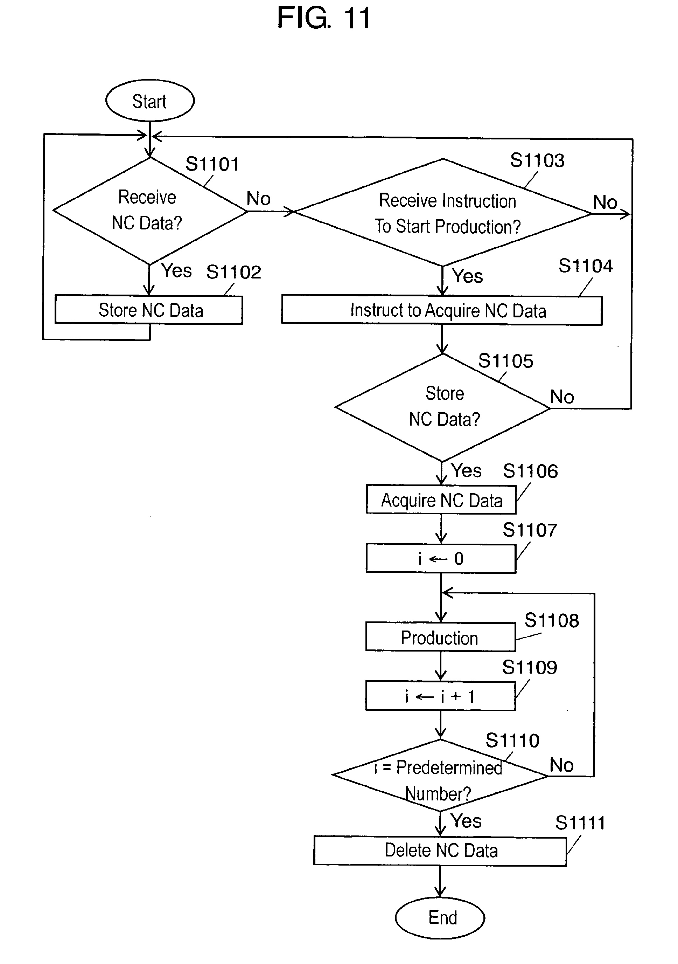

Hereinafter, an operation of production apparatus 1001 of Embodiment 2 will be described with reference to a flowchart shown in of Fig. 11.

Reception unit 100111 determines whether it receives the NC data or not (step S1101).

If reception unit 100111 receives the NC data, storage unit 100112 stores the NC data received at step S1101 (step S1102). Reception unit 100111 determines whether reception unit 100111 receives NC data or not (step S1101).

Production instruction reception unit 10012 determines whether production instruction reception unit 10012 receives an input of an instruction to start production or not (step S1103). If receiving no input of the instruction to start production, reception unit 100111 determines whether reception unit 100111 receives the NC data or not (step S1101). In this case, the "input of an instruction to start production" is input given by, for example, pressing a button for starting production.

If production apparatus 1001 receives the input of an instruction to start production, production unit 10014, according to the instruction received in step S1103, instructs the NC data acquiring unit 1013 to acquire the NC data (step S1104).

NC data acquiring unit 10013 determines whether storage unit 10012 stores the NC data or not, according to the instruction provided at step S1104 (step S1105). If NC data acquiring unit 10013 determines that storage unit 10012 does not have the NC data, reception unit 100111 determines whether reception unit 100111 receives the NC data or not (step S1101).

If determining that storage unit 10112 stores the NC data, NC data acquiring unit 10013 acquires the NC data received by reception unit 100111 at step S1102 (step S1106).

Production unit 10014 initializes a value (i) of the counter (step S1107). Production unit 10014 acquires the NC data from NC data acquiring unit 10013, processes the NC data, and produces the boards (step S1108). Then, production unit 10014 increments the value (i) of the counter (step S1109).

Production unit 10014 determines whether the value (i) is equal to a predetermined number or not (S1110). If determining that the value (i) is not equal to the predetermined number, production unit 10014 processes the NC data and produces the boards (S1108). The predetermined number may be stored in the memory built in the production unit, or may be included in the NC data. Alternatively, production instruction reception unit 10012 may receive the predetermined number (the number of boards to be produced). In this case, production instruction reception unit 10012 may include an input device, such as a touch panel, for receiving the predetermined number (the number of boards to be produced), and software for controlling the input device.

If production unit 10014 determines that the value (i) is equal to the predetermined number at step S1110, NC data deleting unit 10012 deletes the NC data from all the record media storing the NC data received by reception unit 100111 (step S1111). Then, the operation of production apparatus 1001 terminates.

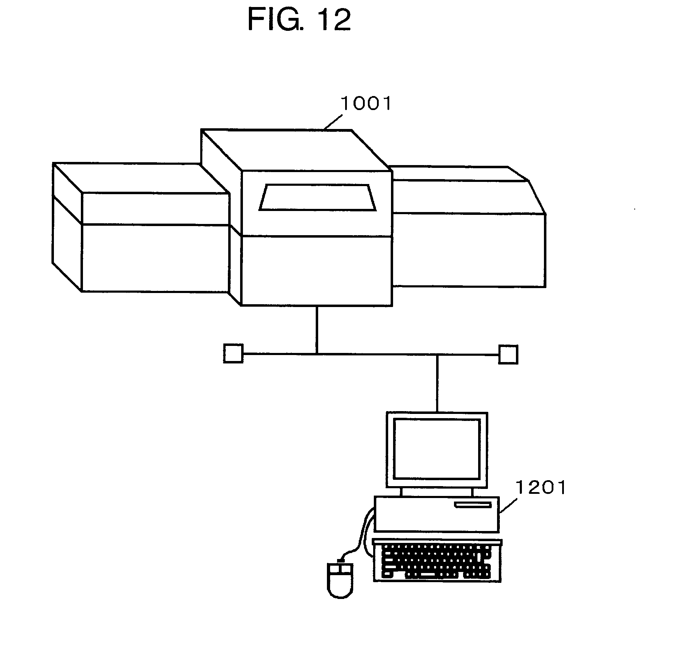

Hereinafter, a specific operation of production apparatus 1001 in accordance with Embodiment 2 will be described. Fig. 12 is a schematic diagram of production apparatus 1001. Production apparatus 1001 is coupled via a network to server 1201 for line management, and to other production apparatuses (not shown). The NC data are stored in server 1201 for line management. Server 1201 transmits the NC data to production apparatus 1001. Reception unit 100111 receives the NC data from server 1201. Storage unit 100112 stores the NC data. Subsequently, if a button of production instruction reception unit 10012 is pressed, production unit 11014 instructs NC data acquiring unit 11013 to acquire the NC data. NC data acquiring unit 11013 acquires the NC data from storage unit 100112.

Next, production unit 10014 acquires the NC data from NC data acquiring unit 10013, processes the NC data, and produces the boards. Production unit 10014 produces the predetermined number of the boards. The predetermined number may be an arbitrary value, and may be previously stored in a memory built in production unit 10014. Alternatively, if receiving the NC data from server 1201, reception unit 100111 may receive the predetermined number as well. The NC data may include information about the number of the boards to be produced after the processing of the NC data. In this case, NC data deleting unit 10015 may delete the NC data after the number of the boards are produced.

Next, after the predetermined number of the boards are produced, NC data deleting unit 10015 deletes the NC data from all the record media (such as storage unit 100112, a record medium built in NC data acquiring unit 10013, and a record medium built in production unit 10014) storing the NC data. If only production unit 10014 stores the NC data, NC data deleting unit 10015 deletes the NC data from the record medium built in production unit 10014. In this case, the NC data stored in storage unit 100112 and NC data acquiring unit 10013 may be deleted after production unit 10014 acquires the NC data.

NC data deleting unit 10015 deletes the NC data after the predetermined number of boards are produced. NC data deleting unit 10015 may delete a portion of the NC data after the portion of the NC data is processed. In other words, NC data deleting unit 10015 deletes the portion of the data after components identified by the portion of the data are mounted on the board. For example, after data "N2P2B14X150Y150V180Z49MH1C(OCF14111), ..." shown in Fig. 5 is processed and the component identified by "Z49MH1C (OCF14111)" are mounted at coordinate "X150Y150" on the board, NC data deleting unit 10015 deletes the data "N2P2B14X150Y150V180Z49MH1C(OCF14111), ...".

As described above, according to Embodiment 2, the NC data can be deleted from production apparatus 1001, thus preventing the risk of appropriation of the NC data. This advantage protects know-how and confidential technical information of an orderer. The board is hiden during the production by being housed in a box connectable to a conveyer so that only the orderer can see a wiring pattern of the board.

A program for implementing the operation of Embodiment 2 causes a computer to operate in the following manner. The computer receives the NC data, and deletes the NC data after the board is produced.

### INDUSTRIAL APPLICABILITY

An information processing apparatus according to the present invention can select a production line most appropriate for producing an object to be manufactured with using NC data.

## Claims

1. An information processing apparatus comprising:
a line information storage unit for storing a plurality of pieces of line information, each of the pieces of line information including
a line identifier for identifying a production line of a board,
board size information indicating a size of the board that can be produced by the production line identified by the line identifier, and
component information about at least one component mountable on the board in the production line identified by the line identifier;
a data reception unit for receiving numerical control (NC) data for producing a first board, the NC data including board size information and first component information about a component mountable on the first board, the board size information indicating a size of the first board;
a line identifier acquiring unit for acquiring a line identifier from a plurality of line identifiers stored in the line information storage unit according to the NC data, the line identifier indicating a first production line capable of producing the first board; and
an output unit for outputting the line identifier acquired by the line identifier acquiring unit.

2. The information processing apparatus of claim 1,
wherein each of the pieces of the line information further includes
production capacity information indicating a production capacity of the production line identified by the line identifier included in each of the pieces of the line information, and
production schedule information indicating a schedule of the board to be produced in the production line,
wherein the data reception unit receives production number information and the NC data, the production number information indicating a number of the first board to be produced, and
wherein the output unit outputs the line identifier acquired and the production schedule of the first board at the first production line.

3. The information processing apparatus of claim 1, wherein the output unit further outputs information indicating a production commission.

4. The information processing apparatus of claim 1, further comprising a charging processor for performing a charge processing according to an output of the output unit.

5. A production apparatus comprising:
a reception unit for receiving numerical control (NC) data;
a production unit for producing an object with using the received NC data; and
a deleting unit for deleting the NC data after the production unit produces the object.

6. The production apparatus of claim 5,
wherein the production unit produces a plurality of objects with using the NC data, and
wherein the deleting unit deletes the NC data after the production unit processes the NC data received by the reception unit and produces one of the plurality of objects.

7. The production apparatus of claim 5,
wherein the production unit produces a plurality of objects with using the NC data; and
wherein the deleting unit deletes the NC data after the production unit produces a predetermined number of a plurality of boards out of the plurality of objects.

8. A board comprising a storage unit for storing numerical control (NC) data, the NC data including board size information and component information about a component mountable on the board, the board size information indicating a size of the board, wherein the board is machined according to the NC data.

9. The circuit board of claim 8, wherein the storage unit is made of a radio-frequency identification.

10. A method of producing a board, comprising:
receiving NC data for producing the board, the NC data including board size information and component information about at least one component mountable on the board, the board size information indicating a size of the board;
acquiring, according to the received NC data, a line identifier indicating a production line capable of producing a first board to be produced according to the received NC data; and
outputting the acquired line identifier.

11. The method claim 10, further comprising outputting information of a production commission for producing the board.

12. A method of producing a board comprising:
receiving production number information and NC data, the production number information indicating a number of boards to be produced;
acquiring, according to the received NC data, a line identifier indicating a production line capable of producing the board to be produced according to the NC data; and
outputting the acquired line identifier and a production schedule of the board at the production line identified by the line identifier.

13. The method of claim 12, further comprising outputting information indicating a production commission for producing the board.

14. A method of producing a board comprising:
receiving NC data;
producing a board in a production apparatus with using the NC data; and
deleting the NC data after said producing the board.

15. A record medium readable by a computer, the record medium storing a program causing the computer to execute:
receiving NC data for producing the board, the NC data including board size information and component information about at least one component mountable on the board, the board size information indicating a size of the board;
acquiring, according to the received NC data, a line identifier indicating a production line capable of producing a first board to be produced according to the received NC data; and
outputting the acquired line identifier.

16. The record medium of claim 15, wherein the program causes the computer to further execute outputting information indicating a production commission for producing the board.

17. A record medium readable by a computer, the record medium storing a program causing the computer to execute:
receiving production number information and NC data, the production number information indicating a number of boards to be produced;
acquiring, according to the received NC data, a line identifier indicating a production line capable of producing the board to be produced according to the NC data; and
outputting the acquired line identifier and a production schedule of the board at the production line identified by the line identifier.

18. The record medium of claim 17, wherein the program causes the computer to further execute outputting information indicating a production commission for producing the board.

19. A record medium readable by a computer, the record medium storing a program causing the computer to execute:
receiving NC data;
producing a board in a production apparatus with using the NC data; and
deleting the NC data after said producing the board.
